# EUROPEAN PATENT APPLICATION

(11) **EP 1 528 666 A1**
(43) Date of publication of application: **04.05.2005**
(21) Application number: 03025301.7
(22) Date of filing: 03.11.2003
(51) Int. Cl.: H03F 1/02, H03F 3/195, H03F 1/30

(54) **Power amplifier circuit configuration and integrated circuit**

(71) Applicant: TriQuint Semiconductor GmbH, 81829 München (DE)
(72) Inventor: Bernhofer, Stefan, 81829 München (DE)
(74) Representative: Ginzel, Christian

(57) **Abstract**

The present invention provides a power amplifier circuit configuration which comprises a signal input terminal (RFin), a signal output terminal (RFout), an amplifier stage (1) connected to the signal input terminal (RFin) and the signal output terminal (RFout), said amplifier stage (1) includes at least one transistor (T1); a biasing circuit (2) connected to the amplifier stage (1) for controlling the operation point of the amplifier stage (1); and a detector circuit (3) connected to the signal input terminal (RFin), said detector circuit (3) being sensitive to the power level of an input signal to change the operation point of the amplifier stage (1) in dependence of the power level of the input signal.

## Description

The present invention relates to a power amplifier circuit configuration and a corresponding integrated circuit. More particularly, the present invention relates to a power amplifier circuit configuration that allows the control of the operating points of a power amplifier, in particular those used for mobile telephones. Typical examples include high power GaAs FET (Field Effect Transistors) or HBT (Heterojuntion Bipolar Transistor) power amplifiers for GSM (Global System for Mobile Communications), EDGE (Enhanced Data for GSM Evolution) and UMTS (Universal Mobile Telecommunications System) applications.

Normally, the linearity of the signal amplification is not mandatory for power amplifiers used in GSM mobile telecommunications systems, but in several applications a linear amplification characteristic is nevertheless desired. For example, a linear amplification characteristic becomes important when a fixed level of attenuation should be compensated, e.g. in cars where the cable losses between the mobile phone antenna connector and external antenna need compensation over the full dynamic range of all power levels of the mobile phone. Furthermore, a linear amplification characteristic is necessary when linear systems like UMTS, EDGE or CDMA (Code Division Multiple Access) systems are used.

Due to thermal reasons and due to energy efficiency, the power amplifiers used in mobile telecommunications systems are usually not operated under class A conditions, where best linearity is achieved. Instead, class AB or class B operation conditions are used to keep the thermal stress under control and to achieve high efficiency levels.
However, under these bias conditions the linearity of the signal amplification can degrade considerably when the drain current (collector current) of the power amplifier cannot rise properly in accordance with the rising input power. A possible reason for this behavior can be a too low transconductance of the device, resulting in a transfer characteristic with lower values than 1 dB/dB in the ratio between output power and input power.

It is accordingly an object of the invention to provide a power amplifier circuit configuration, in particular a power amplifier circuit configuration that allows the control of the operating point of a power amplifier, that overcomes the above-mentioned disadvantages of the prior art devices of this general type.

With the foregoing and other objects in view that are provided, a power amplifier circuit configuration according to independent claim 1 and an integrated circuit according to independent claim 20.

Further advantages, features, aspects, and details of the invention are evident from the dependent claims, the description and the accompanying drawings. The claims are intended to be understood as a first non-limiting approach of defining the invention in general terms.

The power amplifier circuit configuration according to independent claim 1 comprises a signal input terminal, a signal output terminal, an amplifier stage connected to the signal input terminal and the signal output terminal, said amplifier stage includes at least one transistor; a biasing circuit connected to the amplifier stage for controlling the operation point of the amplifier stage; and a detector circuit connected to the signal input terminal, said detector circuit being sensitive to the power level of an input signal to change the operation point of the amplifier stage in dependence of the power level of the input signal.

According to a further aspect of the present invention, an integrated circuit as described in independent claim 20 is provided which includes: a signal input terminal, a signal output terminal, an amplifier stage connected to the signal input terminal and the signal output terminal, said amplifier stage includes at least one transistor, a reference transistor connected to the transistor of the amplifier stage so that the reference transistor and the transistor of the amplifier stage form a current mirror, and a detector circuit connected to the signal input terminal, said detector circuit being sensitive to the power level of an input signal to change the operation point of the amplifier stage in dependence of the power level of the input signal.

The described power amplifier circuit configuration or the described integrated circuit, improve the linearity of the signal amplification considerably and can be used, for example, in connection with high power GaAs FET (Field Effect Transistors) or HBT (Heterojuntion Bipolar Transistor) power amplifiers for GSM (Global System for Mobile Communications), EDGE (Enhanced Data for GSM Evolution), UMTS (Universal Mobile Telecommunications System) and CDMA (Code Division Multiple Access) applications.

Furthermore, the power amplifier circuit configuration or the described integrated circuit allow a number of additional benefits. The detector circuit can be operated independent of gate leakage currents and gate leakage drifts. The detector circuit can be operated without thermal compensation (no thermal runaway). The detector circuit needs almost no additional current. In other words, the device PAE (power added efficiency) does not decrease. The power amplifier circuit according to the present invention can be operated with a lower quiescent current. A lower quiescent current of the device reduces power consumption at a low drive operating mode.

In one preferred embodiment of the invention, said detector circuit is directly connected to the amplifier stage to change the operation point of the amplifier stage in dependence of the power level of the input signal. Preferably, said detector circuit is connected to the control terminal of the transistor of the amplifier stage.

In another preferred embodiment of the invention, said detector circuit is connected to the biasing circuit and makes the biasing circuit change the operation point of the amplifier stage in dependence of the power level of the input signal.

In further preferred embodiment of the invention, the biasing circuit comprises a reference transistor connected to the transistor of the amplifier stage so that the reference transistor and the transistor of the amplifier stage form a current mirror. Preferably, the control terminal of the reference transistor and the control terminal of the transistor of the amplifier stage are connected via a low pass filter. Furthermore, it is preferred that the detector circuit is connected to the control terminal of the reference transistor.

The term current mirror circuit should be understood in a wide sense here. The current mirror circuit is formed by two transistors whose control terminals (base terminal or gate terminal) are connected to one another, so that a current in the controlled path of one transistor (collector-emitter current or source-drain current) produces a mirrored current in the controlled path of the other transistor. As a result the currents behave linearly with respect to one another in the area of interest, in an ideal situation.

In order to achieve a good current mirror, the two transistors are preferably identical, so that the linearity of the two currents with respect to one another is evenly maintained , for example, in the event of temperature fluctuations. If, for example, the two transistors also have the same emitter-base area and if the emitters of the two transistors are at the same potential, then the ratio of the two currents is essentially 1.

In another preferred embodiment of the invention, the detector circuit comprises at least one diode and at least one capacitor, preferably functioning as a rectifier. Furthermore, it is preferred, if the detector circuit is connected to the signal input terminal via a capacitor.

In another preferred embodiment of the invention, the detector circuit is connected to a voltage supply, preferably via a voltage divider. Furthermore, it is preferred, if biasing circuit is connected to a voltage supply, preferably via a voltage divider.

In another preferred embodiment of the invention, the reference transistor is connected to the transistor of the amplifier stage so that the reference transistor and the transistor of the amplifier stage form a current mirror, a first transistor whose controlled path is connected in series to the controlled path of the reference transistor; and a second transistor whose control terminal is connected to the controlled path of the control transistor and whose controlled path is connected to the control terminal of the reference transistor. Preferably, the control terminal of the first transistor is connected to the voltage supply via the voltage divider.

Furthermore, it is preferred that the biasing circuit comprises a reference resistor connected in series to the controlled path of the reference transistor.

In another preferred embodiment of the invention, the control terminal of the reference transistor and the control terminal of the transistor of the amplifier stage are connected via a voltage divider. Preferably, at least one diode is connected in parallel to the voltage divider.

In another preferred embodiment of the invention, the power amplifier circuit configuration includes at least two amplifier stages connected in a cascade-type configuration. Preferably, the amplifier stage includes at least one Field Effect Transistor.

Although the invention is illustrated and described herein as embodied in a circuit configuration for controlling the operating point of a power amplifier, it is nevertheless not intended to be limited to the details shown, since various modifications and structural changes may be made therein without departing from the spirit of the invention and within the scope and range of equivalents of the claims.

The construction and method of operation of the invention, however, together with additional objects and advantages thereof, will be best understood from the following description of specific embodiments when read in connection with the accompanying drawings.
- Fig. 1: is a circuit diagram of an embodiment of the power amplifier circuit configuration and the integrated circuit according to the invention;
- Fig. 2: is a circuit diagram of a further embodiment of the power amplifier circuit configuration and the integrated circuit according to the invention;
- Fig. 3: shows a curve of the power output versus the power input of a power amplifier circuit as shown in Fig. 2 but without the detector circuit 3;
- Fig. 4: shows a curve of the power output versus the power input of a power amplifier circuit as shown in Fig. 2 with the detector circuit 3;
- Fig. 5: is a circuit diagram of a further embodiment of an integrated circuit according to the invention; and
- Fig. 6: is a circuit diagram of a still further embodiment of the power amplifier circuit configuration and the integrated circuit according to the invention.

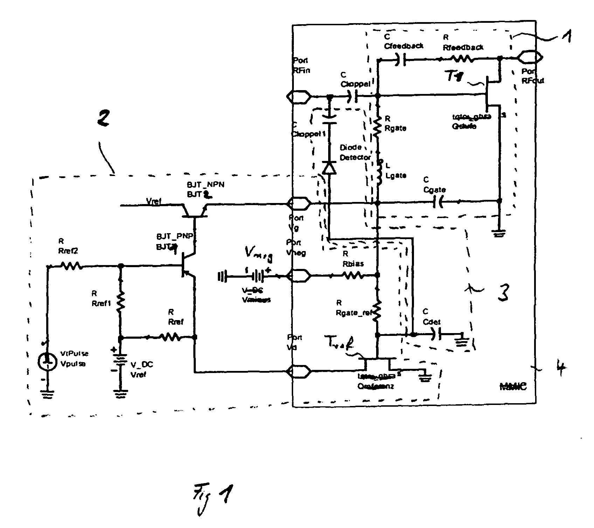

In all the figures of the drawings, sub-features and integral parts that correspond to one another bear the same reference symbol in each case. Referring now to the figures of the drawing in detail and in particularly firstly to FIG. 1 thereof, there is shown a power amplifier circuit configuration and the integrated circuit according to the invention.

The power amplifier circuit configuration comprises a signal input terminal RFin and a signal output terminal Rfout. In order to amplify a signal present at the signal input terminal RFin, an amplifier stage 1 is connected to the signal input terminal RFin. The amplifier stage 1 includes a transistor T1 which is connected to the signal input terminal RFin via a capacitor Ckoppel and which is also connected to the signal output terminal RFout, in order to output the amplified signal. The amplifier stage 1 includes a feedback loop (Cfeedback, Rfeedback) which connects the control terminal of the transistor T1 with the signal output terminal Rfout.

Furthermore, the power amplifier circuit configuration shown in Fig. 1 comprises a biasing circuit 2 connected to the amplifier stage 1 for controlling the operation point of the amplifier stage 1. The biasing circuit 2 includes a reference transistor Tref connected to the transistor T1 of the amplifier stage 1 so that the reference transistor Tref and the transistor T1 of the amplifier stage 1 form a current mirror. In addition, the biasing circuit 2 includes a first transistor BJT 1 (in the present example a PNP bipolar transistor), whose controlled path is connected in series to the controlled path of the reference transistor Tref, and a second transistor BJT 2 (in the present example a NPN bipolar transistor), whose control terminal is connected to the controlled path of the first transistor BJT 1 and whose controlled path is connected to the control terminal of the reference transistor Tref. Thereby, the control terminal of the first transistor BJT 1 is connected to the voltage supply Vref via the voltage divider Rref1 and Rref2.

Furthermore, the biasing circuit 2 comprises a reference resistor Rref connected in series to the controlled path of the reference transistor Tref, whereby the reference resistor Rref basically determines the current that flows through the controlled path of the reference transistor Tref.

For pulsed application, the biasing circuit 2 further comprises a pulsed voltage supply Vpulse, which in a low state allows the biasing circuit 2 to set the operation point for the amplifier stage 1 and deactivates the biasing circuit 2 otherwise.

Furthermore, the power amplifier circuit configuration shown in Fig. 1 comprises a detector circuit 3 connected to the signal input terminal RFin via a capacitor Ckoppell. The detector circuit 3 comprises a diode Ddet and a capacitor Cdet, which function as a rectifier of the input signal. Accordingly, the detector circuit 3 is sensitive to the power level of an input signal. In operation, the detector circuit 3 is used to change the operation point of the amplifier stage 1 in dependence of the power level of the input signal. In particular, the detector circuit 3 makes the biasing circuit change the operation point of the amplifier stage in dependence of the power level of the input signal as described below.

Fig. 1 also shows an embodiment of the integrated circuit 4 according to the present invention. The integrated circuit 4 comprises the signal input terminal RFin, the signal output terminal RFout and the amplifier stage 1. Furthermore, the integrated circuit 4 comprises the detector circuit 3 and the reference transistor Tref.

In operation, voltage supply Vref supplies, via the voltage divider Rref1 and Rref2, a predetermined voltage to the control terminal (base terminal) of the first transistor BJT 1. This voltage is increased by the voltage between base terminal and emitter terminal (0,6 .. 0,7V) and supplied to the resistor Rref and, via the terminal Vd, to the reference transistor Tref. Due to the fact that the resistor Rref experiences a constant voltage drop, a constant current flows through the resistor Rref. This current (minus the emitter current of BJT 1) is injected into the controlled path (drain-source path) of the transistor Tref.

The emitter current ( collector current) of the first transistor BJT 1 is supplied to the control terminal of the second transistor BJT 2. The collector current of the second transistor BJT 2 flows via the terminal Vg and via the resistor Rbias to the voltage supply Vneg, which leads to a voltage drop over the resistor Rbias. This voltage drop leads to a voltage level supplied to the control terminal of the transistor Tref so that the current supplied from the resistor Rref is allowed to flow through the transistor Tref.

The voltage level supplied to the control terminal of the transistor Tref is also supplied, via the resistor Rgate_ref and via the low pass filter (Rgate, Lgate, Cgate), to the control terminal of the transistor T1 of the amplifier stage 1. Due to the fact that the dimension of the transistors T1 and Tref have a predetermined ratio, the currents through these two transistors also have this predetermined ratio. Accordingly the operation point of the amplifier stage 1 is set.

The baising circuit not only sets the operation point of the amplifier stage 1 but it also maintains the operation point of the amplifier stage 1, for example in the event of temperature fluctuations. When, due to an increase in temperature of the transistor Tref, the current through the transistor Tref starts to rise, the voltage at the terminal Vd decreases. Accordingly, the base-emitter voltage of the transistor BJT 1 decreases which decreases the collector current of transistor BJT 1. This leads to a decrease of the collector current of transistor BJT 2 and, accordingly, to a decrease of the voltage drop over the resistor Rbias and a decrease of the voltage level supplied to the control terminal of the transistor Tref. As a consequence the current through the transistor Tref remains constant. Thus, the biasing circuit provides a controlled gate voltage with low impedance to the transistor T1 but has no additional influence on the drain current under large signal conditions.

In order to keep the thermal stress under control and to achieve high efficiency levels, the power amplifier circuit configuration shown in Fig. 1 is, for example, operated under class AB conditions. This implies that due to the input signal, the drain current of the transistor T1 of the amplifier stage may become as high as three times the quiescent current. Without the additional detector circuit, it may happen that output power does not rise proportionally to the input power (gain compression). The reason for this behavior may be based in an insufficient transconductance of the amplifier stage. However, the detector circuit 3 is designed to increase the drain current of the transistor T1 of the amplifier stage, in order to reduce the gain compression considerably.

Thereby, the detector circuit works as follows. A portion of the input signal is supplied via the capacitor Ckoppel1 to the diode Ddet and the capacitor Cdet, which function as a rectifier of the input signal and which form a negative voltage at the control terminal of the transistor Tref. This negative voltage is proportional to the rf power and, therefore, the drain current of the transistor Tref tends to become lower with higher power levels of the input signal. However, the biasing circuit 2 does not allow a decrease of the drain current of the transistor Tref by increasing the voltage at the terminal Vg. Thus, the biasing circuit 2 increases the gate voltage of the transistor T1 of the amplifier stage 1 and, thereby, changes the operating point of the amplifier stage 1. Due to the increase of the gate voltage of the transistor T1 of the amplifier stage 1, the drain current of the transistor T1 of the amplifier stage 1 also increases. The resulting behavior of the power amplifier circuit is comparable with one with higher transconductance and compensates gain compression by a rising drain current which gives better linearity over a wide range of rf power level.

Furthermore, the detector circuit leads to a number of additional benefits. The detector circuit is independent of gate leakage currents and gate leakage drifts. The detector circuit needs no thermal compensation (no thermal runaway). The detector circuit needs almost no additional current. In other words, the device PAE (power added efficiency) does not decrease. The power amplifier circuit according to the present invention can be operated with a lower quiescent current. A lower quiescent current of the device reduces power consumption at low drive operating mode.

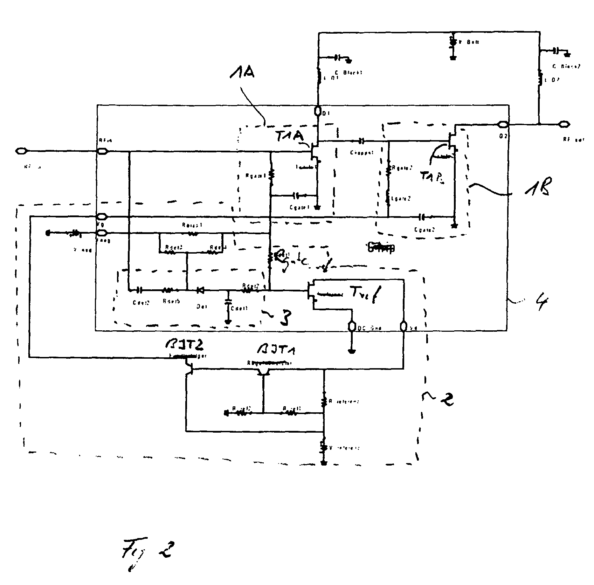

Fig. 2 shows a further embodiment of a power amplifier circuit configuration and the integrated circuit according to the present invention. The design of the power amplifier circuit configuration shown in Fig. 2 basically corresponds to the design of power amplifier circuit configuration shown in Fig. 1 with the following exceptions.

Instead of one amplifier stage the power amplifier circuit configuration shown in Fig. 2 includes two amplifier stages 1A and 1B which are connected in a cascade-type configuration. Furthermore, the two amplifier stages 1A and 1B are connected to a voltage supply Vbatt that provides, via two low pass filters, the supply voltages for the transistors T1A and T1B.

The detector circuit 3 shown in Fig. 2 is connected to the voltage supply Vneg via a voltage divider Rdet3 and Rdet4. The voltage divider Rdet3 and Rdet4 determines the DC operation point of the detector circuit. Preferably, operation point of the detector circuit is chosen in a manner that the quiescent current is close to zero and that the voltage drop over the diode Ddet is equal to the kink voltage of the diode. Accordingly, the rectified signal voltage does not have to provide the kink voltage which leads to a higher sensibility of the detector circuit. The voltage divider determines the "starting point" of the detector circuit within the dynamic range of the power amplifier circuit.

The detector circuit 3 shown in Fig. 2 further comprises the resistors Rdet2 and Rdet5. The resistor Rdet2 in connection with Rgate_ref determine the steepness and the control limits of the detector circuit. The resistor Rdet5 determines the portion of the input signal that is supplied to the detector circuit 3.

In operation, The diode Ddet and the capacitor Cdet rectify the input signal and form a negative voltage at the resistor Rdet2. The current from the second transistor BJT 2 is now divided between two paths. A portion of the current still flows via the resistor Rbias to the voltage supply Vneg. Another portion of the current flows via the resistors Rgate_ref and Rdet2 into the detector circuit 3. Due to the fact that the biasing circuit 2 maintains the gate voltage of the transistor Tref at a constant level, the voltage drop over the resistor Rgate_ref leads to an increase of the voltages supplied to the transistors of the amplifier stages 1A and 1B. As a consequence, the drain currents increase with an increased input power level and the gain of the amplifier stages does not decrease.

Again, the detector circuit 3 leads to a number of additional benefits. The detector circuit 3 is independent of gate leakage currents and gate leakage drifts. The detector circuit needs no thermal compensation (no thermal runaway). The detector circuit needs almost no additional current. In other words, the device PAE (power added efficiency) does not decrease. The power amplifier circuit according to the present invention can be operated with a lower quiescent current. A lower quiescent current of the device reduces power consumption at low drive operating mode.

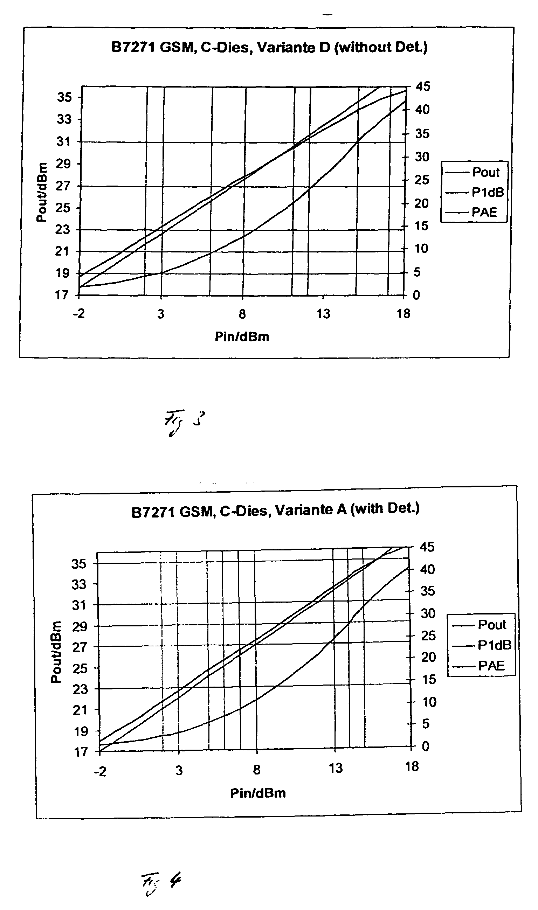

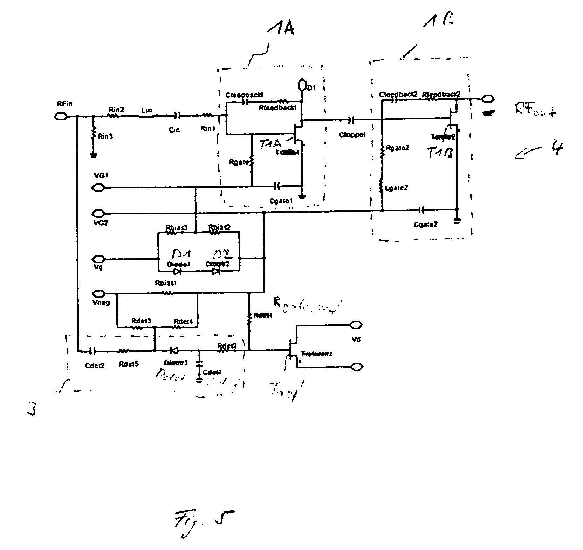

Fig. 3 shows a curve of the power output versus the power input of a power amplifier circuit as shown in Fig. 2 but without the detector circuit 3. Thereby, the output power at 1 dB gain compression is about 29 to 30 dBm. In comparision thereto, Fig. 4 shows a curve of the power output versus the power input of a power amplifier circuit as shown in Fig. 2 with the detector circuit 3. The Pout vs. Pin characteristic gives a Pout at 1 dB gain compression of 35 dBm. The measurements were taken under the same external conditions and with the same quiescent current. As can be seen from Fig. 3 and Fig. 4 the power amplifier circuit according to the present invention gives better linearity over a wide range of rf power level.

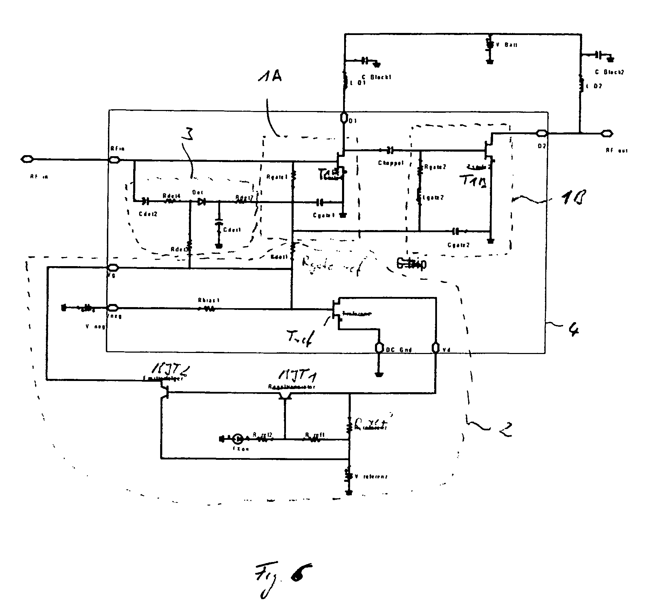

Fig. 5 shows a further embodiment of an integrated circuit 4 according to the present invention. The design of the integrated circuit 4 shown in Fig. 5 basically corresponds to the design of the integrated circuit 4 shown in Fig. 2 with the following exceptions.

In Fig. 5, the control terminal of the reference transistor Tref and the control terminal of the transistor T1A of the amplifier stage 1A are connected via the voltage divider formed by the resistors Rbias2, Rbias3. Parallel to the resistors Rbias2, Rbias3 two diodes D1 and D2 are arranged. In the present example, the two diodes D1 and D2 lead to a constant voltage drop of ca 2,4 V over the resistors Rbias2, Rbias3.

The voltage divider Rbias2, Rbias3 allows for different operation points for the two amplifier stages 1A and 1B. As an example, with the help of the voltage divider Rbias2, Rbias3 it is possible to supply a higher gate voltage to the transistor T1A than to the transistor T1B.

Furthermore, the integrated circuit 4 shown in Fig. 6 comprises an input network Cin, Lin, Rin1, Rin2 and Rin3,i order to provide a predetermined input impedance (for example 50) for the input signal.

Fig. 6 shows a still further embodiment of a power amplifier circuit configuration and the integrated circuit according to the present invention. The design of the power amplifier circuit configuration shown in Fig. 6 is similar to the design of power amplifier circuit configuration shown in Fig. 2 with the following exceptions.

In contrast to the power amplifier circuit configuration shown in Fig. 2, the detector circuit 3 used in Fig. 6 is directly connected to the amplifier stages 1A and 1B. In this embodiment detector circuit 3 forms a positive detector voltage, which, in addition to the gate voltage of the transistor Tref, is supplied via the voltage divider Rdet2 and Rgate_ref to the gate terminals of the transistors T1A and T1B. Accordingly, an increased power level in the input signal leads again to a higher drain current of the transistors T1A and T1B and, therefore, to a higher output power level.

It is also possible for the circuit response to be improved further by additional resistors, inserted capacitors and inductances in the circuit according to the invention. Provided they reflect the fundamental concept of this circuit, these variations are included in the scope of the invention.

## Claims

1. A power amplifier circuit configuration comprising:
a signal input terminal (RFin);
a signal output terminal (RFout);
an amplifier stage (1; 1A, 1B) connected to the signal input terminal (RFin) and the signal output terminal (RFout), said amplifier stage (1; 1A, 1B) includes at least one transistor (T1; T1A, T1B);
a biasing circuit (2) connected to the amplifier stage (1; 1A, 1B) for controlling the operation point of the amplifier stage (1; 1A, 1B); and
a detector circuit (3) connected to the signal input terminal (RFin), said detector circuit (3) being sensitive to the power level of an input signal to change the operation point of the amplifier stage (1; 1A, 1B) in dependence of the power level of the input signal.

2. The power amplifier circuit configuration according to claim 1, wherein said detector circuit (3) is directly connected to the amplifier stage (1; 1A, 1B) to change the operation point of the amplifier stage (1; 1A, 1B) in dependence of the power level of the input signal.

3. The power amplifier circuit configuration according to claim 2, wherein said detector circuit (3) is connected to the control terminal of the transistor (T1; T1A, T1B) of the amplifier stage (1; 1A, 1B).

4. The power amplifier circuit according to one of the preceding claims, wherein said detector circuit (3) is connected to the biasing circuit (2) and makes the biasing circuit (2) change the operation point of the amplifier stage (1; 1A, 1B) in dependence of the power level of the input signal.

5. The power amplifier circuit configuration according to one of the preceding claims, wherein the biasing circuit (2) comprises a reference transistor (Tref) connected to the transistor (T1; T1A, T1B) of the amplifier stage (1; 1A, 1B) so that the reference transistor (Tref) and the transistor (T1; T1A, T1B) of the amplifier stage (1; 1A, 1B) form a current mirror.

6. The power amplifier circuit configuration according to claim 5, wherein the control terminal of the reference transistor (Tref) and the control terminal of the transistor (T1; T1A, T1B) of the amplifier stage (1; 1A, 1B) are connected via a low pass filter (Rgate, Lgate, Cgate).

7. The power amplifier circuit configuration according to claim 5 or 6, wherein said detector circuit (3) is connected to the control terminal of the reference transistor (Tref).

8. The power amplifier circuit configuration according to one of the preceding claims, wherein said detector circuit (3) comprises at least one diode (Ddet) and at least one capacitor (Cdet).

9. The power amplifier circuit configuration according to one of the preceding claims, wherein said detector circuit (3) is connected to the signal input terminal (RFin) via a capacitor (Ckoppel1).

10. The power amplifier circuit configuration according to one of the preceding claims, wherein said detector circuit (3) is connected to a voltage supply (Vneg).

11. The power amplifier circuit configuration according to claim 10, wherein said detector circuit (3) is connected to a voltage supply (Vneg) via a voltage divider (Rdet3, Rdet4) .

12. The power amplifier circuit configuration according to one of the preceding claims, wherein said biasing circuit (2) is connected to a voltage supply (Vref).

13. The power amplifier circuit configuration according to one of the preceding claims, wherein said biasing circuit (2) is connected to a voltage supply (Vref) via a voltage divider (Rref1, Rref2).

14. The power amplifier circuit configuration according to one of the preceding claims, wherein the biasing circuit (2) comprises
a reference transistor (Tref) connected to the transistor (T1; T1A, T1B) of the amplifier stage (1; 1A, 1B) so that the reference transistor (Tref) and the transistor (T1; T1A, T1B) of the amplifier stage (1; 1A, 1B) form a current mirror;
a first transistor (BJT1) whose controlled path is connected in series to the controlled path of the reference transistor (Tref); and
a second transistor (BJT2) whose control terminal is connected to the controlled path of the first transistor (BJT1)and whose controlled path is connected to the control terminal of the reference transistor (Tref).

15. The power amplifier circuit configuration according to claim 14, wherein the control terminal of the first transistor (BJT1) is connected to the voltage supply (Vref) via the voltage divider (Rref1, Rref2).

16. The power amplifier circuit configuration according to one of the claims 5 to 15, wherein said biasing circuit (2) comprises a reference resistor (Rref) connected in series to the controlled path of the reference transistor (Tref).

17. The power amplifier circuit configuration according to one of the claims 5 to 16, wherein the control terminal of the reference transistor (Tref) and the control terminal of the transistor (T1A) of the amplifier stage (1A) are connected via a voltage divider (Rbias2, Rbias3).

18. The power amplifier circuit configuration according to claim 17, wherein at least one diode (D1, D2) is connected in parallel to the voltage divider (Rbias2, Rbias3).

19. The power amplifier circuit configuration according to one of the preceding claims, wherein said power amplifier circuit configuration includes at least two amplifier stages (1A, 1B) connected in a cascade-type configuration.

20. The power amplifier circuit configuration according to one of the preceding claims, wherein said amplifier stage (1; 1A, 1B) includes at least one Field Effect Transistor (T1; T1A, T1B).

21. An integrated circuit comprising:
a signal input terminal (RFin);
a signal output terminal (RFout);
an amplifier stage (1; 1A, 1B) connected to the signal input terminal (RFin) and the signal output terminal (RFout), said amplifier stage (1; 1A, 1B) includes at least one transistor (T1; T1A, T1B);
a reference transistor (Tref) connected to the transistor (T1; T1A, T1B) of the amplifier stage (1; 1A, 1B) so that the reference transistor (Tref) and the transistor (T1; T1A, T1B) of the amplifier stage (1; 1A, 1B) form a current mirror; and
a detector circuit (3) connected to the signal input terminal (RFin), said detector circuit (3) being sensitive to the power level of an input signal to change the operation point of the amplifier stage (1; 1A, 1B) in dependence of the power level of the input signal.

22. The integrated circuit according to claim 21, wherein said detector circuit (3) is directly connected to the amplifier stage (1; 1A, 1B) to change the operation point of the amplifier stage (1; 1A, 1B) in dependence of the power level of the input signal.

23. The integrated circuit according to claim 22, wherein said detector circuit (3) is connected to the control terminal of the transistor (T1; T1A, T1B) of the amplifier stage (1; 1A, 1B).

24. The integrated circuit according to one of claims 21 to 23, wherein said detector circuit (3) is connected to the control terminal of the reference transistor (Tref).

25. The integrated circuit according to one of claims 21 to 24, wherein said detector circuit (3) comprises at least one diode (Ddet) and at least one capacitor (Cdet).

26. The integrated circuit according to one of claims 21 to 25, wherein said detector circuit (3) is connected to the signal input terminal (RFin) via a capacitor (Ckoppel1).

27. The integrated circuit according to one of claims 21 to 26, wherein the control terminal of the reference transistor (Tref) and the control terminal of the transistor (T1; T1A, T1B) of the amplifier stage (1; 1A, 1B) are connected via a low pass filter (Rgate, Lgate, Cgate).

28. The integrated circuit according to one of claims 21 to 27, wherein said power amplifier circuit configuration includes at least two amplifier stages (1A, 1B) connected in a cascade-type configuration.

29. The integrated circuit according to one of claims 21 to 28, wherein the integrated circuit is realized as monolithic microwave integrated circuit.

30. The integrated circuit according to one of the claims 21 to 29, wherein the control terminal of the reference transistor (Tref) and the control terminal of the transistor (T1A) of the amplifier stage (1A) are connected via a voltage divider (Rbias2, Rbias3).

31. The integrated circuit according to claim 31, wherein at least one diode (D1, D2) is connected in parallel to the voltage divider (Rbias2, Rbias3).
